Europäisches Patentamt

European Patent Office

Office européen des brevets

(11) Publication number : **0 568 342 A1**

(12) **EUROPEAN PATENT APPLICATION**

(21) Application number : 93303318.5

(22) Date of filing : 28.04.93

(51) Int. Cl.⁵ : **H03K 17/96, G06K 11/16**

(30) Priority : 30.04.92 GB 9209364

(43) Date of publication of application :
03.11.93 Bulletin 93/44

(84) Designated Contracting States :
DE ES FR IT

(71) Applicant : VARITRONIX LIMITED
4/F Liven House, 61-63 King Yip Street
Kwun Tong, Kowloon (HK)

(72) Inventor : Chuan, Yiu Shum
4/F Liven House, 61-63 King Yip Street
Kwung Tong, Kowloon (HK)
Inventor : Lee, Goon Nam
4/F Liven House, 61-63 King Yip Street
Kwung Tong, Kowloon (HK)
Inventor : Liao, York
4/F Liven House, 61-63 King Yip Street
Kwung Tong, Kowloon (HK)
Inventor : Poon, Ying Ming
4/F Liven House, 61-63 King Yip Street
Kwung Tong, Kowloon (HK)

(74) Representative : Edward Evans & Co.
Chancery House 53-64, Chancery Lane
London WC2A 1SD (GB)

(54) **A touch sensitive device.**

(57) The invention relates to an electronic touch sensitive screen device 100 which may be an integral part of electronic data handling equipment which may be portable as by being hand held for example. The device 100 comprises a circuit including two electronic paths or leads 1 and 2, adapted to be connected with a source 3 for providing a pulse train of identical desired form (in the embodiment a square wave pulse train), an electronic comparator device 4 such as in the embodiment a D-type Flip-Flop connected with the two paths 1 and 2 and adapted to receive input signals 5 and 6 respectively from the path 1 and 2 and to provide an output 7 commensurate therewith, and a touch contact 8 of the ohmic kind along one of the paths 1. The path 1 is earthed or grounded at 9.

FIG. 2

EP 0 568 342 A1

The invention relates to a touch sensitive device, particularly a two dimensional direct contact touch screen operative on the discharge property of the human body.

Data provision by way of screens utilising touch sensing of the screen is known, and essentially comprises the ability to detect contact with a human body usually via part thereof such as a finger. Such sensing is usually achieved either by capacitive coupling or by optical sensing. Some prior touch systems are set out below:

### TOUCH SYSTEMS

| | System Type | Resolution | Response Time | Trans- missivity | Reliability | Stylus |
|---|---|---|---|---|---|---|
| 1. | Capacitive overlay | 1024 × 1024 touch points | 15–25 msec | 50–85% | Sensor – 2M[a] Controller – > 176 khours[b] | Requires a conductive stylus |
| 2. | Resistive overlay | 200 touch points per inch | 13–48 msec | 55–70% | Sensor – 1.2M[a] Controller – 86–118 khours[b] | All types |
| 3. | Surface acoustic wave (SAW) | 15 touch points per inch | 53–59 msec | 92% | Sensor – 50M[a] Controller – 86–118 khours[b] | Fingers only |
| 4. | Piezo- electric | Up to 60 touch points | 25–45 msec | 92% | Sensor – 4M[a] Controller – N/A | All types |
| 5. | Scanning IR | 1953–12,065 touch points | 18–40 msec | 100% | > 138 khours[b] | All types |

[a]TPL = touches per location.
[b]MTBF = mean time between failures.

However, such a system as identified at 1. above can have the disadvantage of insensitivity because the capacitative coupling has necessarily to rely on the electrical characteristic of the user at the time of coupling, while system 2 suffers from low transmissivity and a short lifetime. This insensitivity leads to unreliability because the electrical characteristic parameter(s) of the operator tend to have a very wide range, for example human resistance and capacitance can vary by as much as two orders of magnitude depending on such factors as skin type, perspiration level, ambient humidity, mental state and the like. Moreover systems 3, 4 and 5, while being relatively independent of the operator suffer, with system 1 and 2, the disadvantages of a complicated and expensive construction, and high power consumption.

It is an object of the invention to seek to mitigate these disadvantages.

According to a first aspect of the invention there is provided an electronic touch sensitive screen device, comprising a circuit including two paths adapted to be connected with a source for providing a pulse train of identical desired form along the two paths, a comparator adapted to compare the signals received from the two paths and to provide an output commensurate therewith, and a contact along one of the paths, adapted to be touched by at least part of a person for actuating the device, the arrangement being such that when part of a person touches the contact, the body of the person acts as a discharge outlet and the waveform is at least delayed and the comparator compares the input wave forms at each cycle from both paths to provide a commensurate output.

The comparator may comprise a D-type Flip-Flop. This provides a relatively simple yet efficient construction.

The source may provide a square wave pulse train. This, again, provides a relatively simple device, which is nevertheless efficient, particularly where the device comprises a touch sensitive screen device which may be portable. A compact, inexpensive device is thus provided.

The contact may comprise two contact elements to which are exposed for contact by part of a person, suit-

EP 0 568 342 A1

ably by a finger of a person operating the device.

The contact may comprise two touch pads. This provides for positive operation and seeks to avoid mis-triggering.

The two touch pads may be connected by leads running from opposite sides of a substrate. Again, this seeks to avoid mis-triggering as the leads cannot be touched together.

The substrate may include an array of a plurality of said contacts. This provides for a multiplicity of choice and operation.

The substrate may comprise a glass plate. This provides a transparent device which can be readily applied over a display.

According to a second aspect of the invention there is provided electronic equipment associated with a device as hereinbefore defined.

A touch sensitive electronic device is schematically illustrated, by way of example, with reference to the accompanying drawings.

Fig.1 is a schematic arrangement of a touch screen device according to the invention showing the circuit in one mode;

Fig.2 is a view similar to Fig.1 with the circuit actuated by touch; and

Fig.3 shows a sensor pattern for use in or with a device according to Figs. 1 or 2.

Referring to the drawings, there is shown schematically an electronic touch sensitive screen device 100 which may be an integral part of electronic data handling equipment which may be portable as by being hand held for example. The device 100 comprises a circuit including two electronic paths or leads 1 and 2, adapted to be connected with a source 3 for providing a pulse train of identical desired form (in the embodiment a square wave pulse train), an electronic comparator device 4 such as in the embodiment a D-type Flip-Flop connected with the two paths 1 and 2 and adapted to receive input signals 5 and 6 respectively from the path 1 and 2 and to provide an output 7 commensurate therewith, and a touch contact 8 of the ohmic kind along one of the paths 1. The path 1 is earthed or grounded at 9.

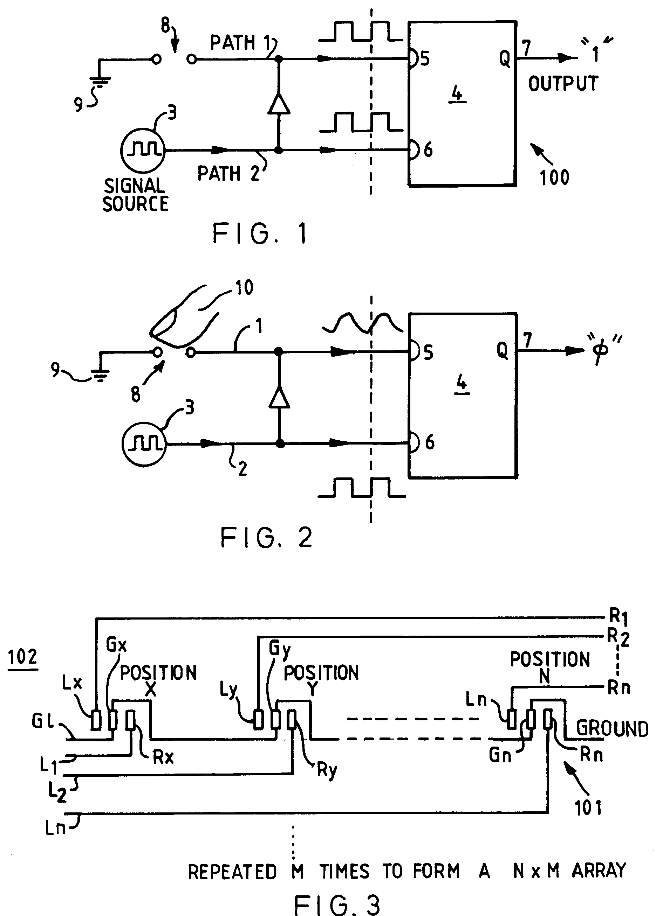

In use, when part of a person such as a finger 10 is placed in contact with one path 1 at the contact 8, the body of the person via the finger essentially serves as a large reservoir for capacitive discharge, thus causing a delay as well as distortion of the waveform at the input 5 of the one path 1 to the comparator 4, which compares at each cycle the inputs from the two paths 1 and 2. If both inputs 5, 6 are high then they are essentially identical and the output 7 is "1", as shown in Fig.1. If on the other hand one of the inputs 5 is low, the comparator 4 monitors this, marks the comparison and provides an output 7 which is "0", as shown in Fig.2. Thus the comparator 4 provides an output commensurate with the inputs received from the two paths 1 and 2. In an example, a delay at the input 5 of the one path 1 as compared to that of the record path 2 would give an output of "0" when the comparison is made at a time T (shown by a dashed line in Figs. 1 and 2). In an undelayed case or state of the circuit, the output 7 is "1".

Thus, even though different operators use the device 100, or the same operator uses the device 100 under different environmental or emotional states, a consistent output is achieved because whilst the environmental and/or operator parameters change, and there are thus significantly different delay times, nevertheless there is a delay which can be monitored by the comparator which therefore provides a change of state at the output 7 so that reliable operation of equipment such as a computer can be achieved using the device 100 described with reference to the drawings. Moreover the device 100 described is simple, and extremely power conservative, so making it cost effective and rendering it ideal for incorporation in portable devices where power consumption is of great concern. A portable device incorporating the invention can thus have a low weight owing to use of small batteries which nevertheless have a long life.

It will be understood that Figs. 1 and 2 show a device 100 with one contact, or touch pad, by way of example. It will equally be understood that in such direct contact sensing it is necessary to try to obviate mis-triggering by contacting the leads rather than the pads, particularly when there is a matrix or array of pads. Fig.3 shows an array or pattern 101 of pads which seeks to mitigate mis-triggering in an N x M array where each contact or sensing position X, Y..N comprises two pads Lx + Rx, with in the embodiment a shared earth pad, Gx, Gy, Gn. though this earth (ground) pad Gx etc. is optional. The respective leads for each pad as shown run from opposite sides of a plate 102 to the respective pad, and it is then not possible to touch both leads at the same time. In use, however, the finger 10 must touch both pads at a touch position X, Y..N in order to confirm actuation at that position. An earth (ground) pad Gx etc. is readily incorporated as shown at each touch position X etc., the pads being connected by a common earth (ground) line G1, the earth(s) providing an enhanced discharge path and thus greater sensitivity in the system. As shown an array N x M is built up by repeating the layout shown in Fig.3. Such an array can be provided by etching the pattern or array on the plate 102 or any suitable substrate such as a sheet of glass coated with a suitable coating such as indium tin oxide (ITO). This then provides a transparent but rugged yet relatively simple touch plate 102 which can be mounted on

3

top of a display such as an LCD display for operation thereof.

It will be understood that the term "pad" used herein refers to any means for contact by a finger or thumb of an operator of the device or of electronic equipment with which it is associated.

## Claims

1. An electronic touch sensitive screen device, comprising a circuit, characterised by two paths (1, 2) adapted to be connected with a source (3) for providing a pulse train of identical desired form along the two paths (1, 2), a comparator (4) adapted to compare the signals received from the two paths (1, 2) and to provide an output commensurate therewith, and by a contact (8) along one of the paths (1, 2), adapted to be touched by at least part of a person for actuating the device, whereby when part of a person touches the contact (8), the body of the person acts as a discharge outlet and the waveform is at least delayed and the comparator (4) compares the input wave forms at each cycle from both paths (1, 2) to provide a commensurate output.

2. A device according to Claim 1, characterised by the comparator (4) comprising a D-type Flip-Flop.

3. A device according to Claim 1 or Claim 2, characterised by the source (3) providing a square wave pulse train.

4. A device according to any preceding claim, characterised by the device (10) being portable.

5. A device according to any preceding claim, characterised by the contact (8) comprising two contact elements which are exposed for contact by part of a person.

6. A device according to any preceding claim, characterised by the contact (8) comprising two touch pads (Lx, Rx).

7. A device according to Claim 6, characterised by the two touch pads (Lx, Rx) being connected by leads running from opposite sides of a substrate (102).

8. A device according to Claim 7, characterised by the substrate (102) including an array (NxM) of a plurality of the contacts (Lx, Rx).

9. A device according to Claim 8, characterised by the array (NxM) comprising a plurality of sensing positions each comprising two touch pads.

10. A device according to Claim 9, characterised by an earth pad (Gx).

11. A device according to Claim 9 or Claim 10, characterised by each touch pad having respective leads which run in opposite direction.

12. A device according to Claim 11, characterised by the substrate (102) comprising a glass plate.

13. Electronic equipment, characterised by being associated with a device (100) according to any preceding claim.

FIG. 1

FIG. 2

FIG. 3

REPEATED M TIMES TO FORM A N x M ARRAY

European Patent Office

**EUROPEAN SEARCH REPORT**

Application Number

EP 93 30 3318

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | ELECTRONIC DESIGN vol. 26, no. 15, July 1978, HASBROUCK HEIGHTS, NEW JERSEY US page 98 TOM HINIKER 'Noise immunity of capacitive switch improves with flip-flop interface' | 1-5,13 | H03K17/96 G06K11/16 |
| Y | * page 98, left column, paragraph 2 * * figure 1 * | 6 | |
| Y | GB-A-2 022 264 (GENERAL ELECTRIC COMPANY) 12 December 1979 * page 4, line 27 - line 31 * * figure 3 * | 6 | |
| A | US-A-4 290 052 (CHARLES W.EICHELBERGER ET AL.) 15 September 1981 * figure 2 * | 7 | |
| | | | TECHNICAL FIELDS SEARCHED (Int. Cl.5 ) |
| | | | H03K G06K |

The present search report has been drawn up for all claims

| Place of search | Date of completion of the search | Examiner |
|---|---|---|
| THE HAGUE | 18 AUGUST 1993 | CIARELLI N. |